# EUROPEAN PATENT APPLICATION

(11) **EP 4 596 158 A1**
(43) Date of publication of application: **06.08.2025**
(21) Application number: 24218973.6
(22) Date of filing: 11.12.2024
(51) Int. Cl.: B23K 26/0622, B23K 26/08, B23K 26/352, B23K 101/16, B23K 103/00

(54) **LASER PROCESSING MACHINE AND LASER PROCESSING METHOD**

(30) Priority: 31.01.2024 JP 2024013783
(71) Applicant: Kataoka Corporation, Kyoto-shi, Kyoto 601-8203 (JP)
(72) Inventor: MAEDA, Satoru, Kyoto, 601-8203 (JP); AKAGI, Tatsuya, Kyoto, 601-8203 (JP); NAKAMOTO, Masayuki, Kyoto, 601-8203 (JP)
(74) Representative: Seemann & Partner Patentanwälte mbB

(57) **Abstract**

A laser processing machine for performing laser processing on a target film to be processed while feeding a film wound in a roll shape. The laser processing machine includes a suction table having a suction port formed on an upper surface side and configured to hold the target film in a flat state by suction, a drive mechanism configured to cause the suction table to reciprocate in a film conveyance direction, an unwinding device located upstream of the suction table in the film conveyance direction and configured to hold the film, a winding device located downstream of the suction table in the film conveyance direction and configured to wind up the target film after being processed, and a plurality of first irradiation units configured to irradiate a target surface to be processed of the target film held by suction by the suction table with a laser beam.

## Description

### TECHNICAL FIELD

The present disclosure relates to a laser processing machine for patterning a thin film solar cell.

### BACKGROUND ART

In a process of manufacturing a thin film solar cell, several hundred patterning processing are performed on a film-shaped substrate by a laser processing machine. Usually, a plurality of processing heads are arranged to simultaneously perform a plurality of patterning processing in order to improve productivity, and the number of processing heads that can be arranged in a space is limited, and thus the several hundred patterning processing can be efficiently performed by reciprocating a film to be processed or the processing heads (for example, see JP2012-66281A).

A supply form of the film to be processed includes a "sheet form" in which the film is supplied one by one and a "roll form" in which the film is supplied in a roll shape. In the related art, by adopting an oscillator of a nanosecond laser capable of transmitting laser by an optical fiber, a film to be processed is reciprocated in a case in which the supply form of the film is a sheet form, and a processing head is reciprocated in a case in which the supply form of the film is a roll form, thereby implementing efficient patterning processing in any case.

In recent years, in order to improve processing quality or narrow a processing line width, an ultrashort pulse laser having a pulse width in a femtosecond order to a picosecond order has been used instead of the nanosecond laser. The ultrashort pulse lasers have less thermal influence on the panel as compared with the nanosecond laser, and are suitable for high-precision micro-processing.

However, the ultrashort pulse laser is not suitable for fiber transmission because the ultrashort pulse laser is likely to cause fiber breakage or laser change. In general, a laser is transmitted by using a space transmission method. Therefore, an optical path length from an oscillator to the processing head becomes long. In addition, in the laser processing machine having the plurality of processing heads, each processing head performs a plurality of patterning processing while moving each processing head in units of several millimeters in a vertical direction with respect to a laser scanning direction, and thus the optical path length is changed due to the movement in the vertical direction. Therefore, when the ultrashort pulse laser transmitted by using the space transmission method is used, it is difficult to cause the processing head to reciprocate, and in particular, in the case in which the supply form of the film is a roll form, there is a problem that it is difficult to ensure the reliability of processing accuracy or the processing quality.

### SUMMARY OF INVENTION

Aspect of non-limiting embodiments of the present disclosure relates to provide a laser processing machine that implements highly accurate and highly efficient patterning processing using an ultrashort pulse laser even when a supply form of a film is a roll form.

Aspects of certain non-limiting embodiments of the present disclosure address the features discussed above and/or other features not described above. However, aspects of the non-limiting embodiments are not required to address the above features, and aspects of the non-limiting embodiments of the present disclosure may not address features described above.

According to an aspect of the present disclosure, there is provided a laser processing machine for performing laser processing on a target film to be processed while feeding a film wound in a roll shape, the target film being a part of the film wound in the roll shape, the laser processing machine including:
a suction table having a suction port formed on an upper surface side and configured to hold the target film in a flat state by suction;
a drive mechanism configured to cause the suction table to reciprocate in a film conveyance direction in which the film is conveyed;
an unwinding device located upstream of the suction table in the film conveyance direction and configured to hold the film wound in the roll shape;
a winding device located downstream of the suction table in the film conveyance direction and configured to wind up the target film after being processed; and
a plurality of first irradiation units configured to irradiate a target surface to be processed of the target film held by suction by the suction table with a laser beam.

According to an aspect of the present disclosure, there is provided a laser processing method for performing laser processing on a target film to be processed while feeding a film wound in a roll shape, the target film being a part of the film wound in a roll shape, the laser processing being performed with a laser beam having a pulse width in a picosecond order or a femtosecond order, the laser processing machine including:
a transmission step of spatially transmitting the laser beam to a position of the target film;
a film conveyance step of holding the target film in a flat state by suction and of causing the target film to reciprocate in a film conveyance direction in which the film is conveyed;
an absorption step of absorbing bending of the target film, the bending being generated in conjunction with the reciprocating operation of the target film; and
a laser processing step of irradiating a target surface to be processed of the target film held by suction with the laser beam.

### BRIEF DESCRIPTION OF DRAWINGS

Exemplary embodiment(s) of the present invention will be described in detail based on the following figures, wherein:
FIG. 1 is a diagram illustrating a configuration of a laser processing machine 1 according to an embodiment.
FIG. 2 is a diagram illustrating a film to be processed 51, vertical processing, and horizontal processing.
FIG. 3 is a perspective view illustrating a configuration of a laser device 3.
FIG. 4 is a top view illustrating the configuration of the laser device 3.
FIG. 5 is a diagram illustrating an optical path during vertical processing.
FIG. 6 is a diagram illustrating an optical path during horizontal processing.
FIG. 7 is a block diagram of an unwinding device 2 and a winding device 4.
FIG. 8 is a functional block diagram illustrating a functional configuration of suction plates 7a and 7b.
FIG. 9 is a functional block diagram illustrating a functional configuration of a suction table 6.
FIG. 10 is a functional block diagram illustrating a functional configuration of a control device 5.
FIG. 11 is a flowchart illustrating operations in the laser processing machine 1.
FIG. 12 is a schematic diagram illustrating an operation during laser processing (vertical processing).
FIG. 13 is a schematic diagram illustrating an operation during laser processing (horizontal processing).
FIG. 14 is a schematic diagram illustrating an operation after processing for one page is finished.
FIG. 15 is a schematic diagram illustrating an operation after processing for one page is finished.

### DESCRIPTION OF EMBODIMENTS

### <Overview>

Here, a laser processing machine 1 according to an embodiment of the present disclosure will be described in detail with reference to the drawings.

A laser processing machine according to one aspect of the present disclosure is a laser processing machine for performing laser processing on a target film to be processed while feeding a film wound in a roll shape, the target film being a part of the film wound in the roll shape, the laser processing machine including:
a suction table having a suction port formed on an upper surface side and configured to hold the target film in a flat state by suction;
a drive mechanism configured to cause the suction table to reciprocate in a film conveyance direction in which the film is conveyed;
an unwinding device located upstream of the suction table in the film conveyance direction and configured to hold the film wound in the roll shape;
a winding device located downstream of the suction table in the film conveyance direction and configured to wind up the target film after being processed; and
a plurality of first irradiation units configured to irradiate a target surface to be processed of the target film held by suction by the suction table with a laser beam.

In the laser processing machine according to another aspect of the present disclosure, wherein the unwinding device and the winding device each include an absorption mechanism configured to operate in conjunction with the reciprocating operation of the suction table and configured to absorb bending of the target film..

The laser processing machine according to another aspect of the present disclosure further includes: a first suction unit disposed upstream of the suction table in the film conveyance direction, having a suction port formed in an upper surface of the first suction unit, and having a suction surface with a width equal to or larger than a width of the film;
a second suction unit disposed downstream of the suction table in the film conveyance direction, having a suction port formed in an upper surface of the second suction unit, and having a suction surface with a width equal to or larger than the width of the film; and
a film conveyance controller configured to control a suction state and a non-suction state of the suction table, the first suction unit, and the second suction unit.

In the laser processing machine according to another aspect of the present disclosure, the suction table, the first suction unit, and the second suction unit each include a switching mechanism configured to switch between the suction state and the non-suction state, and
the film conveyance controller is configured to control the switching mechanism to:
during the processing of the target film, cause the target film to be held by suction with the suction table in the suction state and cause the absorption mechanism to absorb the bending of the target film with the first suction unit and the second suction unit in the non-suction state; and
in a case where the processing of the target film is finished, move the suction table with the suction table in the non-suction state and the first suction unit and the second suction unit in the suction state.

In the laser processing machine according to another aspect of the present disclosure, at least one of the suction table, the first suction unit, or the second suction unit has, on an upper surface thereof, an air outlet for blowing out air.

In the laser processing machine according to another aspect of the present disclosure, the air outlet is the suction port, and
at least one of the suction table, the first suction unit, or the second suction unit is configured to blow out the air from the suction port.

The laser processing machine according to another aspect of the present disclosure further includes: a laser oscillator configured to oscillate a laser beam having a pulse width in a picosecond order or a femtosecond order; and
a first beam transmission unit configured to spatially transmit the laser beam from the laser oscillator to the plurality of the first irradiation units.

In the laser processing machine according to another aspect of the present disclosure, each of the plurality of the first irradiation units includes a first processing nozzle facing the target film and configured to emit the laser beam to the target film.

In the laser processing machine according to another aspect of the present disclosure, the plurality of the first irradiation units are scattered in a direction intersecting the film conveyance direction, and are configured to be moved in the same direction,
the film conveyance controller is configured to cause the suction table to reciprocate in a direction parallel to the film conveyance direction and configured to cause each of the plurality of first processing nozzles to move in a direction intersecting the film conveyance direction, and
the laser processing machine is configured to perform a plurality of patterning processing parallel to the film conveyance direction on the target surface of the target film.

The laser processing machine according to another aspect of the present disclosure further includes: a second irradiation unit disposed at a position spaced apart from the plurality of the first irradiation units and configured to perform patterning processing in the direction intersecting the film conveyance direction; and
a second beam transmission unit configured to spatially transmit the laser beam from the laser oscillator to the second irradiation unit.

The laser processing machine according to another aspect of the present disclosure further includes: the second irradiation unit includes a second processing nozzle facing the target film and configured to emit the laser beam to the target film, and
an optical path switching unit configured to guide the laser beam emitted from the laser oscillator to any one of the plurality of first processing nozzles or the second processing nozzle.

A laser processing method according to one aspect of the present disclosure is a laser processing method for performing laser processing on a target film to be processed while feeding a film wound in a roll shape, the target film being a part of the film wound in a roll shape, the laser processing being performed with a laser beam having a pulse width in a picosecond order or a femtosecond order, the laser processing machine comprising:
a transmission step of spatially transmitting the laser beam to a position of the target film;
a film conveyance step of holding the target film in a flat state by suction and of causing the target film to reciprocate in a film conveyance direction in which the film is conveyed;
an absorption step of absorbing bending of the target film, the bending being generated in conjunction with the reciprocating operation of the target film; and
a laser processing step of irradiating a target surface to be processed of the target film held by suction with the laser beam.

### <Embodiment>

### 1. Process of Manufacturing Thin Film Solar Cell

The laser processing machine 1 is used in a process of manufacturing a thin film solar cell as an example. The process of manufacturing a thin film solar cell includes the following steps (a) to (f). (a) forming a first electrode film; (b) forming a separation groove of the first electrode film (P1 processing); (c) forming a power generation layer; (d) forming a separation groove of the power generation layer (P2 processing); (e) forming a second electrode film; and (f) forming a separation groove of the second electrode film (P3 processing). The laser processing machine 1 is a device configured to perform the P1 processing, the P2 processing, and the P3 processing, and configured to cut and form a plurality of separation grooves that divide the respective layers formed in the previous step into cell units by irradiating the respective layers with a laser beam. Cutting and forming the separation grooves with the laser beam may be referred to as "patterning processing" or "scribing processing". In the present embodiment, a film-type perovskite solar cell will be described as an example of a thin film solar cell.

### 2. Configuration of Laser Processing Machine 1

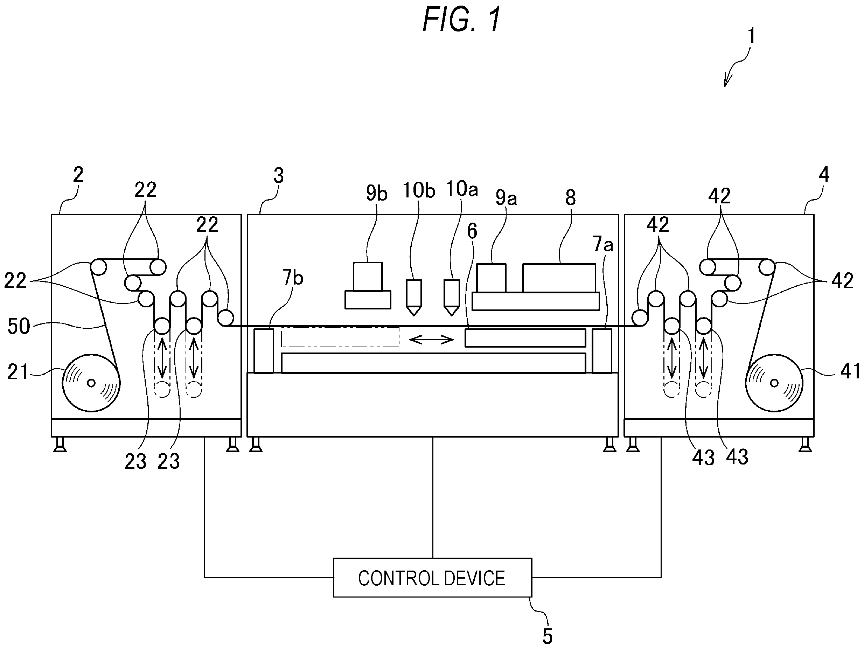

FIG. 1 is a schematic diagram illustrating an overall configuration of the laser processing machine 1 according to the present embodiment. In the present embodiment, a high-output ultrashort pulse laser is used as the laser oscillator 8. The high-output ultrashort pulse laser has a high peak output, and thus is likely to cause fiber breakage or laser change, which is not suitable for fiber transmission. If a photonic crystal fiber (PCF) is used, the fiber transmission may be performed depending on a wavelength of the laser beam to be used. It is difficult for a laser beam having a short wavelength of 532 nm or less to perform fiber transmission.

Therefore, the laser processing machine 1 according to the present embodiment uses a space transmission method. In the case of the space transmission method, optical path lengths from the laser oscillator 8 to irradiation units 10a and 10b are long, laser quality such as a beam size becomes unstable, and a configuration of an optical device becomes complicated. Accordingly, the number of objects to be operated by a servo motor increases, and thus various technical problems such as optical axis deviation and tact delay due to insufficient capacity or vibration of the servo motor occur.

In addition, when the film to be processed is caused to reciprocate, there is a concern about processing quality such as meandering and stability of feed or return speed.

In the present embodiment, the laser processing machine 1 that solves such technical problems and implements high-quality patterning processing will be described.

As illustrated in FIG. 1, the laser processing machine 1 is a Roll-to-Roll device configured to perform patterning processing on an upper surface of a film using a laser device 3 while conveying a long film 50 from an upstream unwinding device 2 to a downstream winding device 4. A control device 5 is a computer system configured to control the unwinding device 2, the laser device 3, and the winding device 4.

The unwinding device 2 includes an unwinding shaft 21, a plurality of guide rolls 22, and one or more accumulation rolls 23. Similarly, the winding device 4 includes a winding shaft 41, a plurality of guide rolls 42, and one or more accumulation rolls 43. The guide rollers 22 and 42 is configured to reduce a tension applied to a substrate (film 50). The guide rollers 22 and 42 is configured to serve as guides during film conveyance. The accumulation rolls 23 and 43 are mechanisms for absorbing the bending of the film 50 generated by the reciprocating operation of the suction table 6 to be described later.

The unwinding device 2 and the winding device 4 may include other components such as a servo motor, a tension measuring device, and a control panel for controlling each component, in addition to these components.

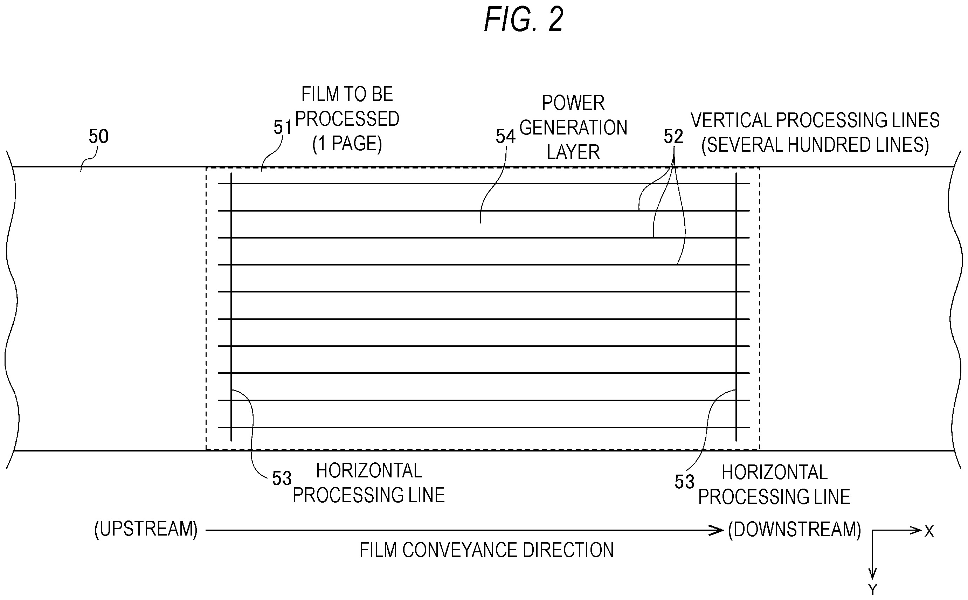

As illustrated in FIG. 2, the laser processing machine 1 is configured to perform patterning processing for each predetermined unit of the long film 50. The predetermined unit of the film 50 is referred to as a film to be processed 51. The laser processing machine 1 is configured to perform vertical processing of cutting several hundreds of grooves (vertical processing lines 52) in a direction (X-axis direction) horizontal to a film conveyance direction with respect to the film to be processed 51, and horizontal processing of cutting one or two grooves (horizontal processing lines 53) in a direction (Y-axis direction) intersecting the film conveyance direction.

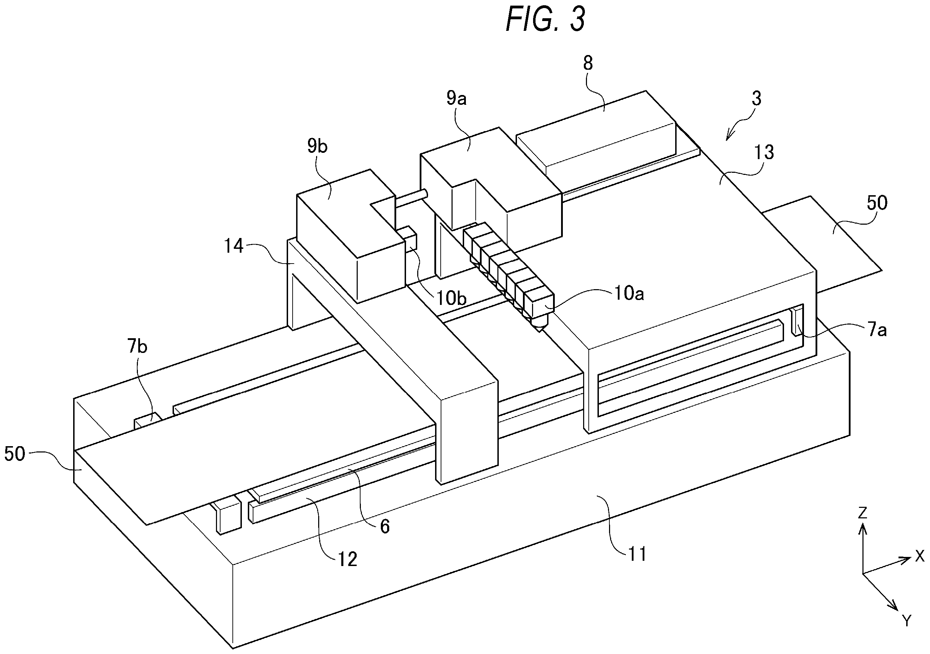

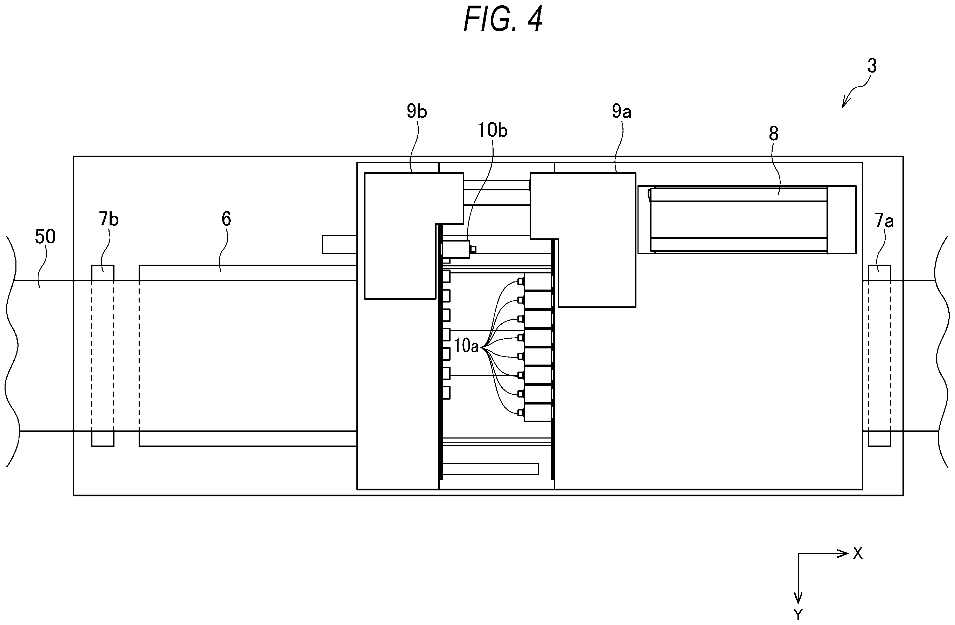

A configuration of the laser device 3 will be described with reference to FIGS. 3 and 4. The laser device 3 includes two parallel rails 12 supported by a main body 11, a suction table 6 configured to be moved in the X-axis direction on the two rails 12, a suction plate 7a disposed downstream of the suction table 6, a suction plate 7b disposed upstream of the suction table 6, the laser oscillator 8 and a vertical processing beam transmission unit 9a which are fixed to a support table 13, a plurality of vertical processing irradiation units 10a configured to be moved in the Y-axis direction by being movably attached to a rail attached to the support table 13, a horizontal processing beam transmission unit 9b fixed to a support table 14, and one horizontal processing irradiation unit 10b configured to be moved in the Y-axis direction by being movably attached to a rail attached to the support table 14. The vertical processing beam transmission unit 9a, the horizontal processing beam transmission unit 9b, the irradiation units 10a, and the irradiation unit 10b are each housed within a housing.

The suction table 6 has a rectangular shape in a plan view, has a size equal to or larger than that of the film to be processed 51, and can hold the film 50 by suction. The suction plates 7a and 7b each have a rectangular shape in a plan view, have a size equal to or larger than a width of the film 50, and is configured to hold the film 50 by suction similar to the suction table 6.

The laser oscillator 8 is a semiconductor laser configured to oscillate an ultrashort pulse laser beam having a pulse width in a picosecond order or a femtosecond order. The laser beam may be a blue laser or a green laser having a wavelength of 400 nm to 523 nm, or may be a red laser having a wavelength of 1,064 nm.

The vertical processing beam transmission unit 9a and the horizontal processing beam transmission unit 9b are configured to spatially transmit the laser beam emitted from the laser oscillator 8 to the irradiation units 10a or the irradiation unit 10b. The vertical processing beam transmission unit 9a and the horizontal processing beam transmission unit 9b include a plurality of optical members in order to prevent a decrease in beam quality while performing spatial transmission. The irradiation units 10a and 10b include processing nozzles. The irradiation units 10a and 10b is configured to emit a laser beam from the processing nozzles to a surface to be processed of the film to be processed 51. The vertical processing irradiation units 10a are implemented by a plurality of axes (eight axes in the present embodiment).

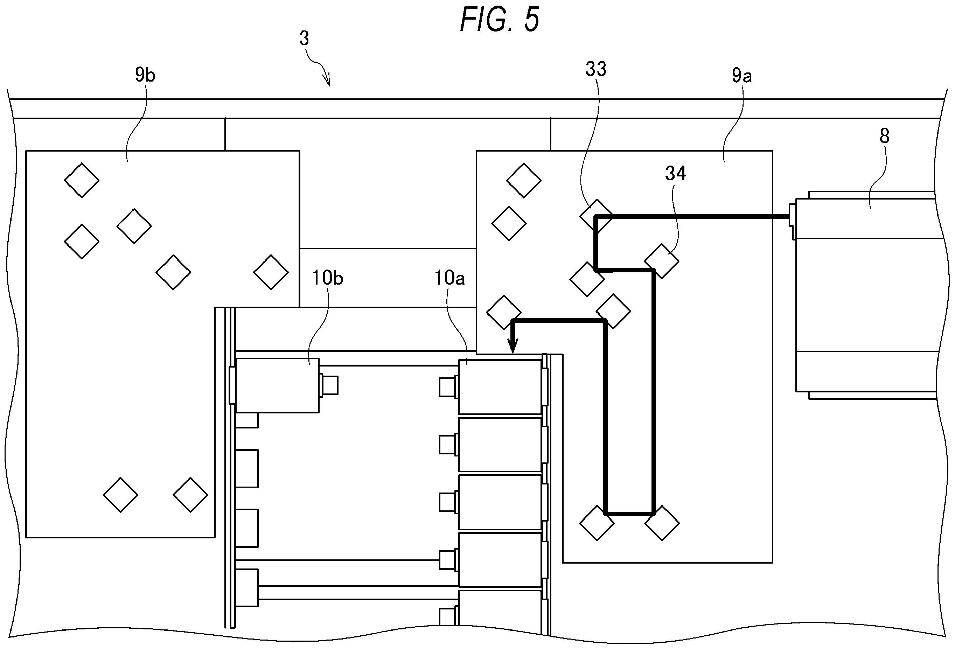

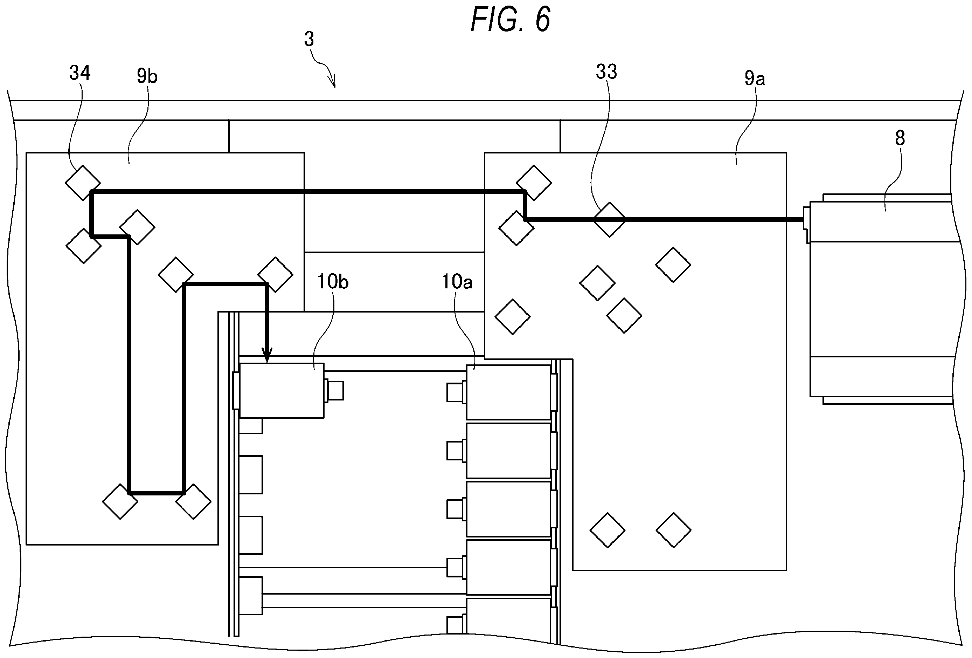

In a case where the laser device 3 performs vertical processing, as illustrated in FIG. 5, the laser beam oscillated from the laser oscillator 8 is spatially transmitted to the vertical processing beam transmission unit 9a and is incident on the irradiation units 10a. On the other hand, in a case where the laser device 3 performs horizontal processing, as illustrated in FIG. 6, the laser beam oscillated from the laser oscillator 8 is spatially transmitted by the horizontal processing beam transmission unit 9b and is incident on the irradiation unit 10b.

The vertical processing beam transmission unit 9a includes an optical path switching mirror 33 in which a mirror is attached to a rotation mechanism unit and other optical components 34. The horizontal processing beam transmission unit 9b also includes a plurality of optical components 34. The optical path switching between the vertical processing and the horizontal processing is performed by the optical path switching mirror 33.

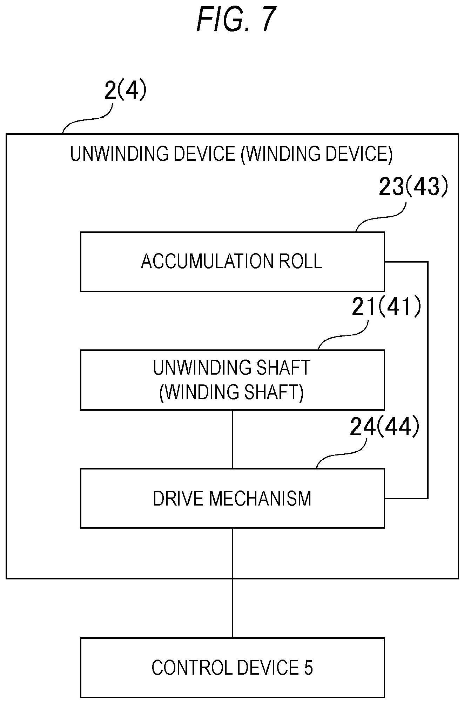

FIG. 7 is a functional block diagram illustrating a functional configuration of the unwinding device 2 and the winding device 4. The unwinding device 2 includes a drive mechanism 24 implemented by a servo motor as an example. The drive mechanism 24 is configured to receive instructions from the control device 5 to rotate the unwinding shaft 21 and move the accumulation roll 23 up and down. Similarly, the winding device 4 includes a drive mechanism 44 implemented by a servo motor. The drive mechanism 44 is configured to receive instructions from the control device 5 to rotate the winding shaft 41 and move the accumulation roll 43 up and down.

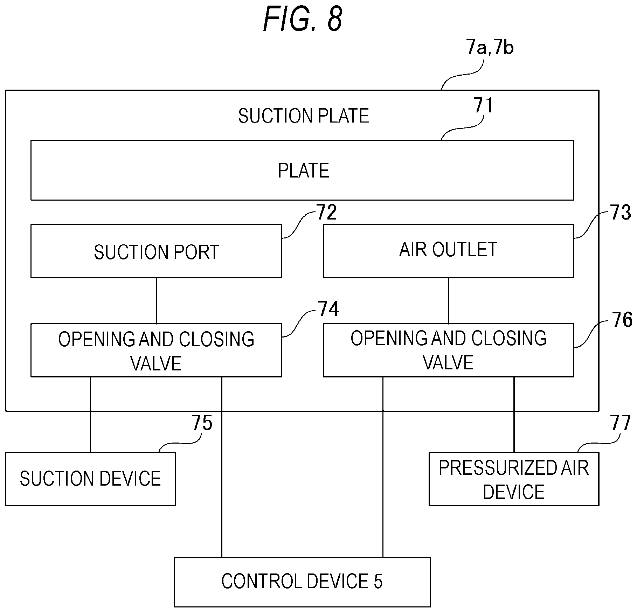

FIG. 8 is a functional block diagram illustrating a functional configuration of the suction plates 7a and 7b. The suction plates 7a and 7b each have a plate 71 that is a plate-shaped member. A plurality of suction ports 72 and a plurality of air outlets 73 are formed on an upper surface of the plate 71. The suction port 72 is connected to a suction device 75 such as a vacuum pump via an opening and closing valve 74. The air outlet 73 is connected to a pressurized air device 77 configured to supply compressed air via an opening and closing valve 76. A position of the opening and closing valve 74 is not limited as long as the opening and closing valve 74 is disposed on a path that connects the suction port 72 and the suction device 75. Similarly, a position of the opening and closing valve 76 is not limited as long as the opening and closing valve 76 is disposed on a path that connects the air outlet 73 and the pressurized air device 77.

The opening and closing valves 74 and 76 are controlled to an open state or a closed state by the control device 5. In a case where the opening and closing valve 74 is in an open state, the suction port 72 is connected to the suction device 75, and vacuum-suctions the film 50 placed on the plate 71. In a case where the opening and closing valve 76 is in an open state, the air outlet 73 is connected to the pressurized air device 77, and causes the film 50 placed on the plate 71 to float under pressure.

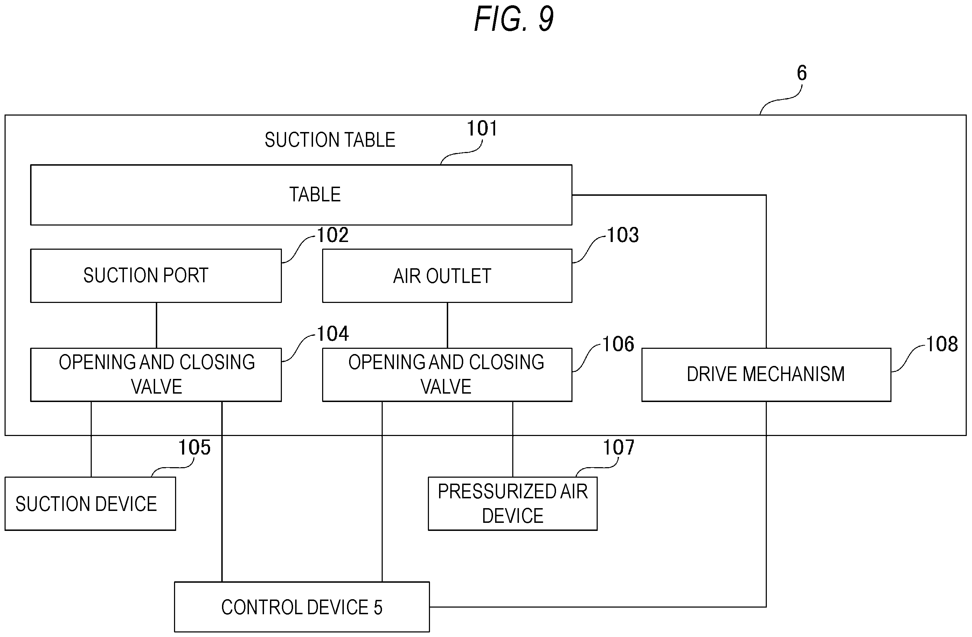

FIG. 9 is a functional block diagram illustrating a functional configuration of the suction table 6. The suction table 6 has a table 101 that is a plate-shaped member. A plurality of suction ports 102 and a plurality of air outlets 103 are formed on an upper surface of the table 101. The suction port 102 is connected to a suction device 105 such as a vacuum pump via an opening and closing valve 104. The air outlet 103 is connected to a pressurized air device 107 configured to supply compressed air via an opening and closing valve 106. A position of the opening and closing valve 104 is not limited as long as the opening and closing valve 104 is disposed on a path that connects the suction port 102 and the suction device 105. Similarly, a position of the opening and closing valve 106 is not limited as long as the opening and closing valve 106 is disposed on a path that connects the air outlet 103 and the pressurized air device 107.

The opening and closing valves 104 and 106 are controlled to an open state or a closed state by the control device 5. In a case where the opening and closing valve 104 is in an open state, the suction port 102 is connected to the suction device 105, and vacuum-suctions the film 50 placed on the table 101. In a case where the opening and closing valve 106 is in an open state, the air outlet 103 is connected to the pressurized air device 107, and causes the film 50 placed on the table 101 to float under pressure. In addition, the table 101 is connected to a drive mechanism 108 implemented by a servo motor or the like, and reciprocates in the film conveyance direction (X-axis direction) by the drive mechanism 108.

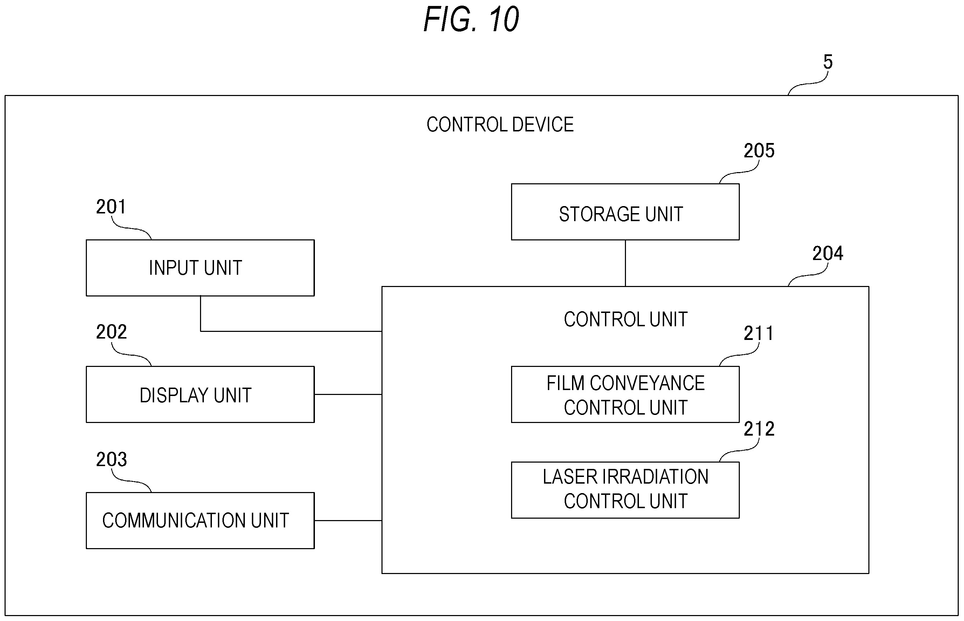

FIG. 10 is a functional block diagram illustrating a configuration of the control device 5. As illustrated in FIG. 10, the control device 5 includes an input unit 201, a display unit 202, a communication unit 203, a controller 204, and a storage unit 205. Specifically, the control device 5 is a computer system including hardware resources such as a central processing unit (CPU), a read only memory (ROM), a random access memory (RAM), a hard disk drive (HDD), a solid state drive (SSD), a display unit, a communication interface, and input devices such as a keyboard and a mouse. The control device is configured to control each device provided in the laser processing machine 1.

The input unit 201 is an input device configured to receive user operations, such as a keyboard, a mouse, and various switches. Data input via the input unit 201 is stored in the storage unit 205.

The display unit 202 includes a display unit, a video codec, a graphics processing unit (GPU), a memory for screen data, and the like, generates a UI screen and the like. The display unit 202 is configured to display the UI screen and the like on the display unit. In a state where the UI screen is displayed on the display unit 202, the user may input information related to the film 50, laser processing conditions, various parameters of the laser oscillator 8, and the like via the input unit 201.

The communication unit 203 is configured to perform information communication with the unwinding device 2, the laser device 3, and the winding device 4 which are connected in a wireless or wired manner.

The controller 204 includes a CPU and a RAM as a working memory. The storage unit 205 is a so-called auxiliary storage device, and is implemented by a non-volatile memory such as an HDD, an SSD, a read only memory (ROM), or a flash memory. The storage unit 205 stores a computer program for controlling the laser processing machine 1 and various data input via the input unit 201, and the CPU of the controller 204 loads the computer program stored in the storage unit 205 in the RAM as a working memory, and executes the computer program to control the unwinding device 2, the laser device 3, and the winding device 4 to perform patterning processing of the film 50.

The controller 204 includes a film conveyance controller 211 and a laser irradiation controller 212, as functional configurations.

The film conveyance controller 211 has a function (a) of synchronously controlling the reciprocating operation of the suction table 6 and the up-down movement of the accumulation rolls 23 and 43 in order to cause the suction table 6 to reciprocate while preventing the bending of the film 50 in the vertical processing. The film conveyance controller 211 has a function (b) of controlling a suction state and a non-suction state of the suction table 6, and the suction plates 7a and 7b. The film conveyance controller 211 has a function (c) of controlling the rotation of the unwinding shaft 21 and the winding shaft 41 and the up-down movement of the accumulation rolls 23 and 43.

The laser irradiation controller 212 has a function of controlling the laser oscillator 8, the vertical processing beam transmission unit 9a, the horizontal processing beam transmission unit 9b, the irradiation units 10a, and the irradiation unit 10b. Specifically, the laser irradiation controller 212 is configured to perform the adjustment of a beam power of the laser beam emitted from the laser oscillator 8, the optical path switching between the vertical processing and the horizontal processing, and the like.

### 3. Operation of Laser Processing Machine 1

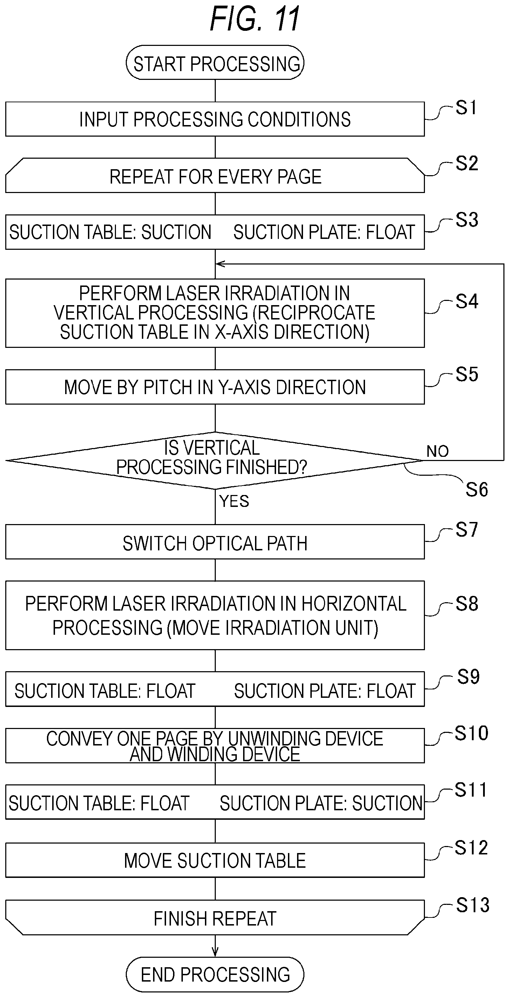

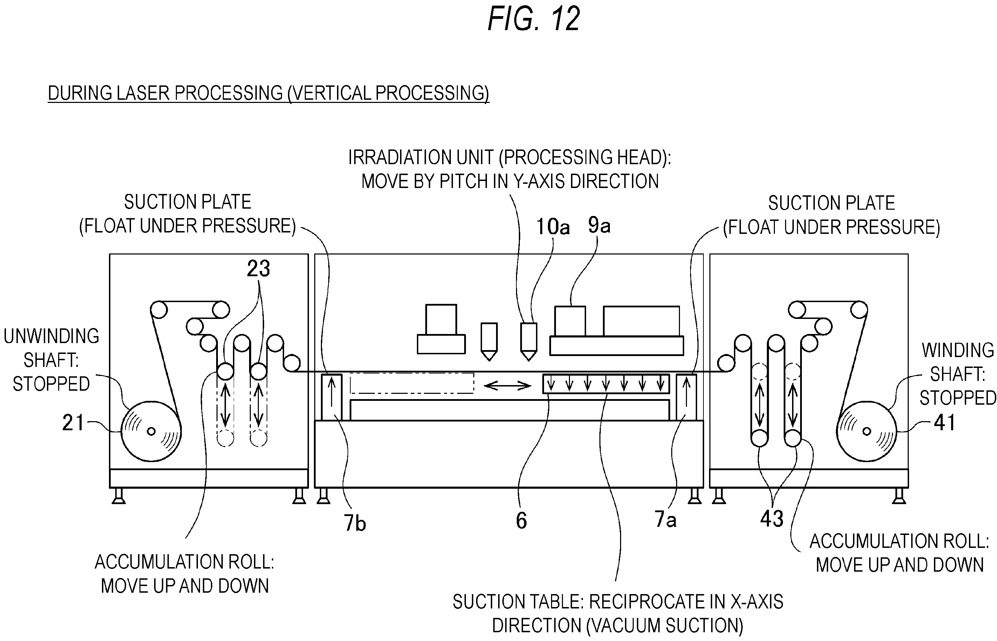

Next, an operation of the laser processing machine 1 will be described with reference to a flowchart in FIG. 11 and schematic diagrams in FIGS. 12 to 15. First, various processing conditions are input via the input unit 201 of the control device 5 (step S1). Next, step S2 to step S13 are repeated for each page of the film to be processed 51.

The film conveyance controller 211 of the control device 5 controls the opening and closing of the valve to bring the suction table 6 into the suction state and to bring the suction plates 7a and 7b into a floating state (step S3). In this state, the film conveyance controller 211 controls the drive mechanism 108 to cause the suction table 6 to reciprocate in the film conveyance direction (X-axis direction). At this time, as illustrated in FIG. 12, the film conveyance controller 211 causes the accumulation rolls 23 and 43 to move up and down in conjunction with the reciprocating operation of the suction table 6 to absorb the bending of the film 50. In addition, the laser irradiation controller 212 controls the laser oscillator 8, the vertical processing beam transmission unit 9a, and the plurality of irradiation units 10a to emit the laser beam in the X-axis direction (step S4).

Each irradiation unit 10a performs reciprocating irradiation a predetermined number of times for processing one vertical processing line 52. In a case where the predetermined number of times of the reciprocating irradiation is finished, each of the irradiation units 10a moves by a pitch in the Y-axis direction under the control of the laser irradiation controller 212 (step S5), and performs the processing of a next vertical processing line 52. The pitch movement in the Y-axis direction is movement in units of several millimeters. Each of the irradiation units 10a repeats step S4 and step S5 (NO in step S6) until the vertical processing for one page is finished. In a case where the vertical processing for one page is finished (YES in step S6), the laser irradiation controller 212 rotates the optical path switching mirror 33 to switch the optical path so that the laser beam is incident on the horizontal processing beam transmission unit 9b (step S7).

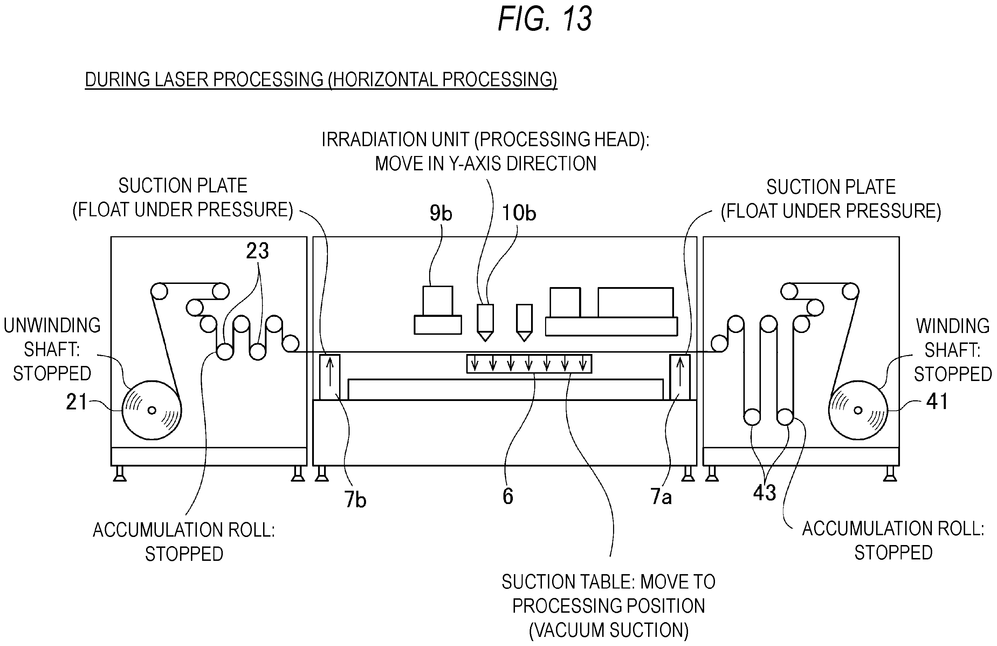

The laser irradiation controller 212 moves the horizontal processing irradiation unit 10b in the Y-axis direction to emit the laser beam in the Y-axis direction, thereby processing the horizontal processing line 53 (step S8). As illustrated in FIG. 13, the film conveyance controller 211 also brings the suction table 6 into the suction state and brings the suction plates 7a and 7b into the floating state during the horizontal processing. The film 50 does not move, and thus the accumulation rolls 23 and 43 are stopped.

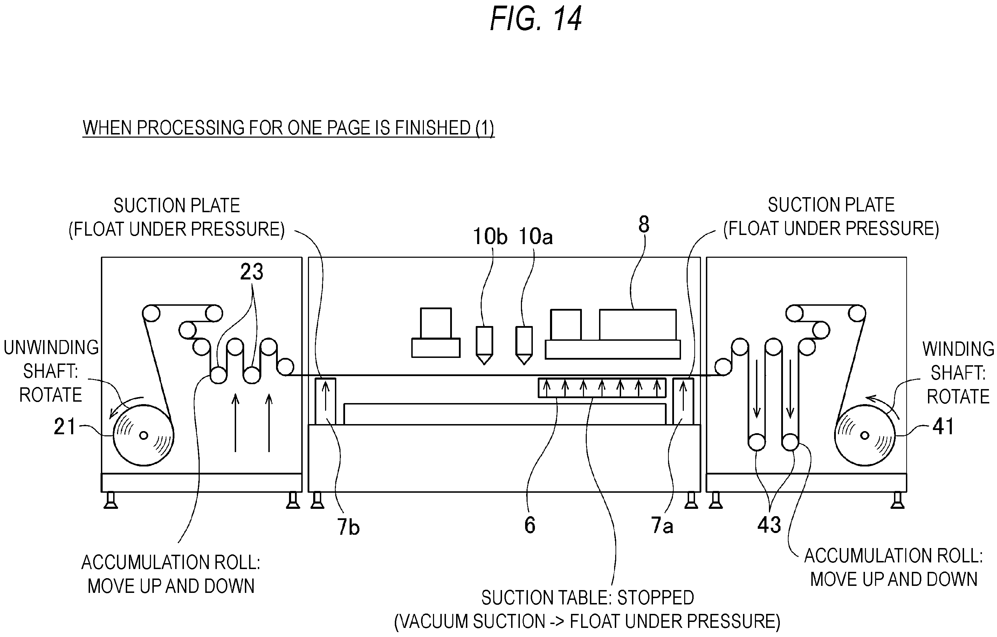

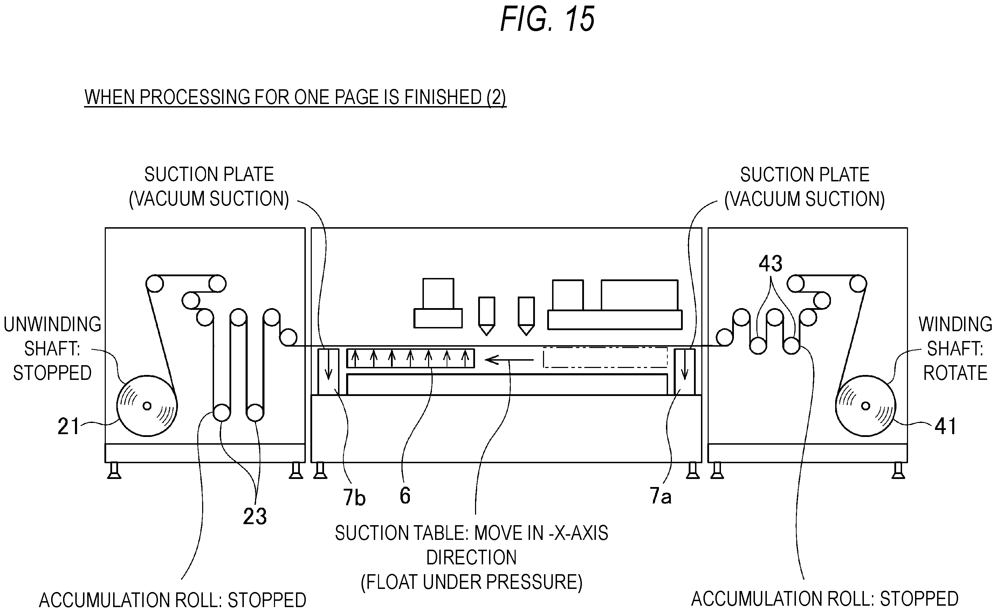

In a case where the horizontal processing is finished and the patterning processing for one page is completed, as illustrated in FIG. 14, the film conveyance controller 211 brings the suction table 6, and the suction plates 7a and 7b into the floating state (step S9), and further controls the unwinding shaft 21, the winding shaft 41, and the accumulation rolls 23 and 43 to convey one page after being processed downstream (step S10). Next, as illustrated in FIG. 15, the film conveyance controller 211 brings the suction plates 7a and 7b into the suction state, maintains the suction table 6 in the floating state (step S 11), and moves the suction table 6 in a -X direction (upstream) (step S 12). Here, the film 50 is suctioned by the suction plates 7a and 7b and does not move, and thus the unwinding shaft 21, the winding shaft 41, and the accumulation rolls 23 and 43 are all stopped. At this time, a next page of the film to be processed 51 is conveyed to the laser device 3, and thus the laser processing machine 1 returns to step S2 and continues the processing.

### 4. Effects of Embodiment

In the laser processing machine 1 of the present embodiment, the operation of the irradiation unit 10a is limited to the pitch movement in the Y-axis direction, which has a short movement distance, and the film 50 is moved in the X-axis direction, thereby ensuring stability of laser quality, which is an issue with the space transmission method. In particular, by causing the film 50 to reciprocate while being held by suction with the suction table 6, and absorbing the slackened film 50 with the accumulation rolls 23 and 43, it is possible to perform the reciprocating operation of the film in a roll form, which was difficult to be implemented by a device in the related art.

In addition, in the laser processing machine 1 of the present embodiment, the suction table 6 in a state of suction-holding the film 50 performs a reciprocating operation with good straightness along an X axis, and thus the meandering of the processing line can be prevented.

In the laser processing machine 1 of the present embodiment, the suction table 6 has a function of vacuum-suctioning the film 50 and a function of floating the film 50 under pressure, and further, the fixed suction plates 7a and 7b having the same function are disposed at both ends of the suction table 6, so that the film 50 can be stably conveyed by a fixed amount for each page. Accordingly, it is possible to prevent positional deviation of each page.

In the laser processing machine 1 of the present embodiment, after one processed page is conveyed downstream, the suction plates 7a and 7b are brought into the suction state, while the suction table 6 is maintained in the floating state and moved in the -X direction (upstream), and thus when the suction table is moved in this manner, it is possible to prevent slackness, positional deviation, or meandering of the film 50, and it is possible to more accurately control a processing position of the processing line on a next page.

### 5. Other Modifications

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.
(1) Regarding the suction ports and the air outlets of the suction plates 7a and 7b, in the present embodiment, the blowing and the suction of air are not simultaneously performed, and thus the suction port 72 and the air outlet 73 may be implemented by a common ventilation port. Similarly, the suction table 6 does not simultaneously perform the blowing and the suction of air, and thus the suction port 102 and the air outlet 103 may be implemented by a common ventilation port.
(2) In the suction table 6 and the suction plates 7a and 7b, the blowing of the compressed air is not essential. It is sufficient that the suction table 6 and the suction plates 7a and 7b are at least capable of switching between the suction state and the non-suction state.
(3) In FIG. 1, the unwinding device 2 and the winding device 4 each include two step rollers (accumulation rolls 23 and 43), but this is not essential. It is sufficient to provide one accumulation roll 23 and one accumulation roll 43.
(4) A method for conveying a film when the processing for one page is finished is not limited to the method described in the above embodiment. For example, the following method may be used. (a) When the processing for one page is finished, the suction table 6 is brought into the floating state, the suction plates 7a and 7b are brought into the suction state, and the suction table 6 is moved upstream. (b) Next, the suction table 6 is brought into the suction state, and the suction plates 7a and 7b are brought into the floating state, and the suction table 6 (and the film 50 held by suction thereon) is conveyed downstream. At this time, with the movement of the suction table 6, the accumulation rolls 23 and 43 at both ends are moved up and down. (c) Finally, the winding shaft 41 and the unwinding shaft 21 are rotated, and the accumulation rolls 43 and 23 are moved up and down to wind and unwind one page of the film.

## Claims

1. A laser processing machine for performing laser processing on a target film to be processed while feeding a film wound in a roll shape, the target film being a part of the film wound in the roll shape, the laser processing machine comprising:
a suction table having a suction port formed on an upper surface side and configured to hold the target film in a flat state by suction;
a drive mechanism configured to cause the suction table to reciprocate in a film conveyance direction in which the film is conveyed;
an unwinding device located upstream of the suction table in the film conveyance direction and configured to hold the film wound in the roll shape;
a winding device located downstream of the suction table in the film conveyance direction and configured to wind up the target film after being processed; and
a plurality of first irradiation units configured to irradiate a target surface to be processed of the target film held by suction by the suction table with a laser beam.

2. The laser processing machine according to claim 1,
wherein the unwinding device and the winding device each include an absorption mechanism configured to operate in conjunction with the reciprocating operation of the suction table and configured to absorb bending of the target film.

3. The laser processing machine according to claim 2, further comprising:
a first suction unit disposed upstream of the suction table in the film conveyance direction, having a suction port formed in an upper surface of the first suction unit, and having a suction surface with a width equal to or larger than a width of the film;
a second suction unit disposed downstream of the suction table in the film conveyance direction, having a suction port formed in an upper surface of the second suction unit, and having a suction surface with a width equal to or larger than the width of the film; and
a film conveyance controller configured to control a suction state and a non-suction state of the suction table, the first suction unit, and the second suction unit.

4. The laser processing machine according to claim 3,
wherein the suction table, the first suction unit, and the second suction unit each include a switching mechanism configured to switch between the suction state and the non-suction state, and
the film conveyance controller is configured to control the switching mechanism to:
during the processing of the target film, cause the target film to be held by suction with the suction table in the suction state and cause the absorption mechanism to absorb the bending of the target film with the first suction unit and the second suction unit in the non-suction state; and
in a case where the processing of the target film is finished, move the suction table with the suction table in the non-suction state and the first suction unit and the second suction unit in the suction state.

5. The laser processing machine according to claim 3,
wherein at least one of the suction table, the first suction unit, or the second suction unit has, on an upper surface thereof, an air outlet for blowing out air.

6. The laser processing machine according to claim 5,
wherein the air outlet is the suction port, and
at least one of the suction table, the first suction unit, or the second suction unit is configured to blow out the air from the suction port.

7. The laser processing machine according to claim 1, further comprising:
a laser oscillator configured to oscillate a laser beam having a pulse width in a picosecond order or a femtosecond order; and
a first beam transmission unit configured to spatially transmit the laser beam from the laser oscillator to the plurality of the first irradiation units.

8. The laser processing machine according to claim 7,
wherein each of the plurality of the first irradiation units includes a first processing nozzle facing the target film and configured to emit the laser beam to the target film.

9. The laser processing machine according to claim 8,
wherein the plurality of the first irradiation units are scattered in a direction intersecting the film conveyance direction, and are configured to be moved in the same direction,
the film conveyance controller is configured to cause the suction table to reciprocate in a direction parallel to the film conveyance direction and configured to cause each of the plurality of first processing nozzles to move in a direction intersecting the film conveyance direction, and
the laser processing machine is configured to perform a plurality of patterning processing parallel to the film conveyance direction on the target surface of the target film.

10. The laser processing machine according to claim 9, further comprising:
a second irradiation unit disposed at a position spaced apart from the plurality of the first irradiation units and configured to perform patterning processing in the direction intersecting the film conveyance direction; and
a second beam transmission unit configured to spatially transmit the laser beam from the laser oscillator to the second irradiation unit.

11. The laser processing machine according to claim 10, further comprising:
the second irradiation unit includes a second processing nozzle facing the target film and configured to emit the laser beam to the target film, and
an optical path switching unit configured to guide the laser beam emitted from the laser oscillator to any one of the plurality of first processing nozzles or the second processing nozzle.

12. A laser processing method for performing laser processing on a target film to be processed while feeding a film wound in a roll shape, the target film being a part of the film wound in a roll shape, the laser processing being performed with a laser beam having a pulse width in a picosecond order or a femtosecond order, the laser processing machine comprising:
a transmission step of spatially transmitting the laser beam to a position of the target film;
a film conveyance step of holding the target film in a flat state by suction and of causing the target film to reciprocate in a film conveyance direction in which the film is conveyed;
an absorption step of absorbing bending of the target film, the bending being generated in conjunction with the reciprocating operation of the target film; and
a laser processing step of irradiating a target surface to be processed of the target film held by suction with the laser beam.
